# EUROPEAN PATENT APPLICATION

(11) **EP 4 753 393 A2**
(43) Date of publication of application: **03.06.2026**
(21) Application number: 25218544.2
(22) Date of filing: 26.11.2025
(51) Int. Cl.: H10B 12/00

(54) **3D DRAM WITH STEP ELECTRODES AND PROCESSING METHOD THEREOF**

(30) Priority: 02.12.2024 KR 20240176905
(71) Applicant: POSTECH Research and Business Development Foundation, Pohang-si, Gyeongsangbuk-do 37673 (KR)
(72) Inventor: CHUNG, Sung Woong, 37673 Gyeongsangbuk-do (KR); HONG, Junyeong, 37673 Gyeongsangbuk-do (KR); KIM, Sehyun, 37673 Gyeongsangbuk-do (KR); KIM, Suhwan, 37673 Gyeongsangbuk-do (KR); CHO, Minseo, 37673 Gyeongsangbuk-do (KR); KANG, Jeonwoong, 37673 Gyeongsangbuk-do (KR)
(74) Representative: Jung, Minkyu

(57) **Abstract**

The present disclosure provides a 3D DRAM using step electrodes capable of effectively reducing an area of a DRAM by using word line layers or bit line layers in the form of the step electrodes.

The 3D DRAM using step electrodes according to the present disclosure is a 3D DRAM using step electrodes, which includes a 3D unit DRAM cell, which includes a pair of access transistor layers and capacitor layers for each of the plurality of stacked layers, in which the 3D unit DRAM cell includes a plurality of word line layers stacked in contact with a common vertical cross-section of the access transistor layers and the capacitor layers formed in each of the plurality of stacked layers, and the plurality of stacked word line layers are electrically connected to gate layers of the access transistors formed in the same layer.

## Description

### CROSS-REFERENCE TO RELATED APPLICATION

This patent document claims the priority and benefits of Korean Patent Application No. 10-2024-0176905 filed on December 02, 2024, the invention of which is incorporated herein by reference in its entirety.

### FIELD OF INVENTION

The present invention relates to a 3D DRAM and a processing method of manufacturing the same, and more particularly, to a 3D DRAM using step electrodes capable of effectively reducing an area of a DRAM by utilizing a word line layer or bit line layer in the form of step electrodes.

### BACKGROUND

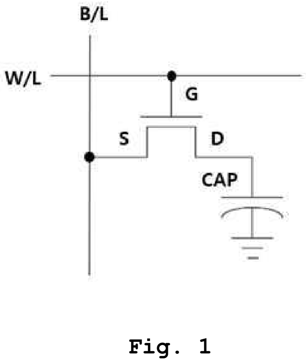

FIG. 1 illustrates a general circuit of one unit DRAM cell.

Referring to FIG. 1, a unit DRAM cell storing 1 bit of data includes an access transistor and a data storage capacitor CAP. A gate terminal G of the access transistor is connected to a word line W/L, a source terminal S is connected to a bit line B/L, and a drain terminal D is connected to the other terminal of a data storage capacitor (CAP), one terminal of which is connected to a ground voltage.

A DRAM array is a structure in which unit DRAM cells having a structure illustrated in FIG. 1 are repeatedly arranged. The structure where the DRAM array is arranged two-dimensionally is referred to as a 2 dimensional DRAM (2D DRAM), and the structure where the 2D DRAMs are stacked is referred to as a three dimensional DRAM (3D DRAM).

The 3D DRAM currently under development will use a structure in which conductive layers, extending vertically or horizontally to a stacking direction of capacitors, are stacked in a step-like manner to form an internal contact.

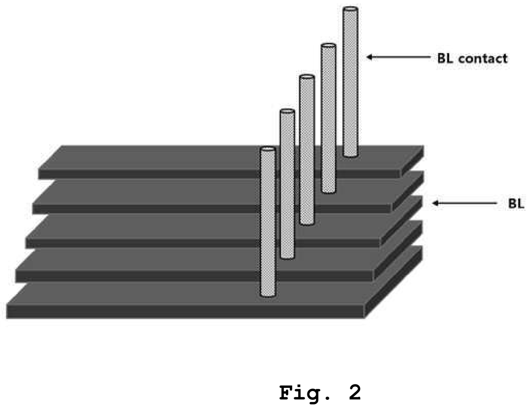

FIGS. 2A to 2C illustrate various examples of the currently proposed 3D DRAM structure.

FIG. 2A illustrates an example in which, assuming that an extending direction of the capacitor is a Y-direction, each word line WL is formed to extend in an X-direction, which is perpendicular to the extending direction (Y-direction) of the capacitor, and the bit line BL is formed to extend vertically in a Z-direction.

In contrast to FIG. 2A, FIG. 2B illustrates an example in which each word line WL extends vertically in the Z direction, while each bit line extends horizontally in the X direction.

FIG. 2C illustrates a case in which the bit line BL extends for a step-like contact when the bit line BL is formed in a horizontal layer, as illustrated in FIG. 2B.

In FIG. 2A, the bit line BL, which is formed in the Z-direction perpendicular to the extending direction (Y-direction) of the capacitor, is relatively easy to form a contact and supply a voltage. On the other hand, the word line WL, which is perpendicular to the extending direction of the capacitor and formed in the horizontal direction (X-direction), i.e., a horizontal word line structure requires a considerable separate planar area between arrays, rather than on the top of the cell array, in order to form the step-like contact of the word line, thereby having the disadvantage of wasting the plane which is an important resource of the semiconductor. The wasted planar area is indicated by a dotted circle in FIG. 2A.

Meanwhile, when the bit line extends horizontally for the step-like contact, as illustrated in FIG. 2C, the length of the bit line increases as the bit line go downward (indicated by the dotted circle in FIG. 2), resulting in a disadvantage of non-uniform capacitance for each bit line. This disadvantage increases the uncertainty of sensing when reading data from memory cells.

### SUMMARY

The technical problem to be solved by the present invention is to provide a 3D DRAM using step electrodes capable of effectively managing an area occupied by a contact by employing word lines or bit lines in the form of novel step electrodes, and a processing method of manufacturing the same.

The technical problems to be solved by the present invention are not limited to the above-mentioned objects. That is, other technical problems that are not mentioned may be obviously understood by those skilled in the art to which the present invention pertains from the following description.

To achieve the technical problems, according to one aspect of the present invention, there is provided a 3D DRAM, in which gate terminals of the access transistors arranged in one layer of the unit DRAM cells are connected to a first word line, gate terminals of access transistors arranged in another layer of the unit DRAM cells are connected to a second word line, a step is formed between a first contact region for electrical connection of the first word line and a second contact region for electrical connection of the second word line, and a direction of the step is formed perpendicular to a direction in which the gate terminals are arranged.

To achieve the technical problems, according to another aspect of the present invention, there is provided a 3D DRAM, in which at least some of the unit DRAM cells stacked at the same position in a vertical direction have gate terminals of the access transistor that commonly form one vertical word line, and each contact region forms a step in a horizontal direction while one terminal of the access transistor is perpendicular to the vertical word line.

To achieve the technical problems, according to another aspect of the present invention, there is provided a processing method for manufacturing a 3D DRAM, including: coating a material having a different etching selectivity to a cell region in which an array of 3D DRAM cells is repeatedly stacked and a contact region in which a step contact is formed for electrical connection to the cell region; performing a first etching on one layer to form the contact region; performing a second etching is performed on a layer positioned one layer below the one layer to form the contact region; and when the second etching is performed, etching a portion formed by the first etching.

The technical problems to be solved by the present invention are not limited to the above-mentioned objects. That is, other technical problems that are not mentioned may be obviously understood by those skilled in the art to which the present invention pertains from the following description.

### BRIEF DESCRIPTION OF DRAWINGS

FIG. 1 is a diagram illustrating a general circuit of a unit DRAM cell.
FIGS. 2A to 2C are diagrams illustrating examples of a structure of a conventional 3D DRAM.
FIG. 3 is a plan view of a 3D DRAM using step electrodes according to an embodiment of the present invention, and illustrates the arrangement of four unit arrays.
FIG. 4 is a diagram illustrating an insulating film that insulates between a cell region and a contact region.
FIG. 5 is a diagram illustrating a 3D DRAM using step electrodes according to an embodiment of the present invention.
FIG. 6 is a diagram illustrating only a contact region in an emphasized view.
FIG. 7 is a diagram illustrating a process of forming a first step electrode in the contact region.
FIG. 8 is a diagram illustrating a process of forming a second step electrode in the contact region.
FIG. 9 is a diagram illustrating a process of forming a third step electrode in the contact region.
FIG. 10 is a three-dimensional view illustrating the contact region and the cell region together after the third step electrode has been formed.
FIG. 11 is a top view of a 3D DRAM according to another embodiment of the present invention.
FIG. 12 is a three-dimensional view illustrating another embodiment of the present invention.
FIG. 13 is a diagram illustrating a portion of the bit line where step electrodes will be formed.
FIG. 14 is a diagram illustrating that the step electrodes are completed in the bit line.

In the drawings like reference numerals are used to indicate like elements.

### SPECIFIC DESCRIPTION

In order to sufficiently understand the present invention, operational advantages of the present invention, and objects accomplished by embodiments of the present invention, the accompanying drawings showing exemplary embodiments of the present invention and contents described in the accompanying drawings should be referred.

Hereinafter, preferred embodiments of the present invention will be described in detail with reference to the accompanying drawings. Throughout the accompanying drawings, the same reference numerals indicate the same members.

For convenience of description, a 3D DRAM refers to a structure in which multiple 2D DRAMs are stacked.

The present invention proposes a structure in which area consumption may be minimized by implementing a plurality of stacked word lines or bit lines in a step-like form when forming the plurality of word lines or bit lines in a horizontal direction in a 3D DRAM.

First, an embodiment of a horizontally extending word line in the 3D DRAM will be described, followed by another embodiment of a horizontally extending bit line.

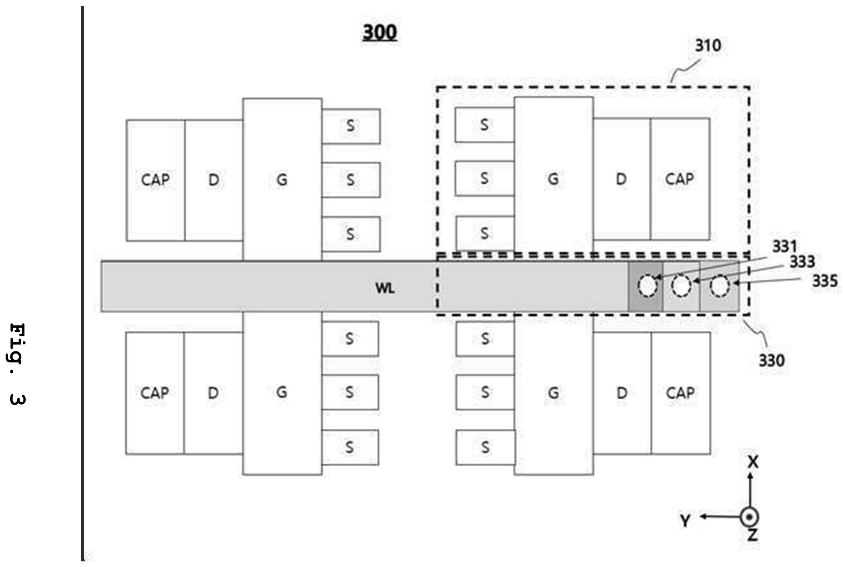

FIG. 3 is a plan view of a 3D DRAM using step electrodes according to an embodiment of the present invention. That is, FIG. 3 is viewed downward in a Z direction, with the word lines WL extending along an X-Y plane and stacked downward.

The drawings of the present invention illustrate a three-dimensional Cartesian coordinate system, if necessary, to aid understanding. Throughout the specification of the present invention, the X-Y plane will be referred to as "horizontal," and the Z direction will be referred to as "vertical." When it is necessary to specify the direction in detail regarding "horizontal," it will be indicated as "horizontal X direction" or "X direction horizontal" to distinguish between the mutually perpendicular X direction and Y direction. In addition, the term "perpendicular" does not necessarily refer to 90°, and is an angle that is slightly smaller or larger than 90° due to tolerable errors in semiconductor manufacturing processes or other causes. Accordingly, the term 'perpendicular' shall also include an angle that, from the perspective of an ordinary skilled person, can be regarded as substantially perpendicular.

In addition, in the stacking structure, the horizontal direction will be referred to as 'one layer,' 'a single layer,' or similar terminology, and in the vertical direction, although the respective layers are at the same position, they will be briefly referred to as 'same position, different layer.'

The following description will focus solely on unit arrays indicated by the dotted lines among four unit arrays, and it will be assumed that each array includes only three DRAM cells. It should be noted that this assumption is merely for convenience to explain the embodiment of the present invention illustrated in FIG. 3 and does not imply that the present invention is limited to this assumption. As illustrated in FIG. 1, a single-bit unit DRAM cell includes one access transistor and one capacitor. Therefore, these unit DRAM cells are arranged horizontally in each layer, and these horizontal arrays are repeatedly stacked in the 3D DRAM.

Referring to FIG. 3, in the 3D DRAM cell, an access transistor composed of a gate G, a drain D, and a source S, and a capacitor CAP are repeatedly arranged in each layer. For convenience of description, the drain D and capacitor CAP regions are merely a simplified planar representation indicating the regions they occupy, and are not intended to specifically illustrate the connection relationships of each component. Three sources S illustrated in FIG. 3 will later be connected to respective vertical bit line BL contacts.

In FIG. 3, the region where memory cells are repeatedly arranged is denoted as a memory cell region 310, and the region where the contact of the word line WL is formed is denoted as a contact region 330. The contacts of each layer of the word line WL are denoted by reference numerals 331, 333, and 335. Each of the contacts 331, 333, and 335 may represent the shapes of electrodes to be later embedded in each layer of the step-like word line. The shapes of the contacts 331, 333, and 335 indicated by round circles may have various shapes depending on the manufacturing process. It should be noted that the terms contact, contact region, step contact, etc., are used interchangeably throughout the specification of the present invention when there is no need to make a detailed distinction between the contact, contact region, step contact, etc.

In addition, since the contact region will be vertically filled with a conductive material, which will later become the electrode, and will be electrically connected to the word line and/or bit line, it should be noted that the terms "contact," "contact region," etc., are also referred to as "electrode" and "step electrode" and are used interchangeably with the same meaning.

It should also be noted that, in the present invention, the step contacts 331, 333, and 335 are formed while extending in the direction in which the capacitor extends, i.e., in the Y direction in FIG. 3. To put this differently, in the case of the horizontal word line, the steps are gradually formed in a direction perpendicular to the word line direction (X direction) of the cell region 310. In other words, the step contacts 331, 333, and 335 are formed by extending along a wall surface where the capacitors are stacked, with a vertical insulating film therebetween. In another representation, the steps are formed in the longitudinal direction of the capacitor. These representations are used to describe the same structure in various ways.

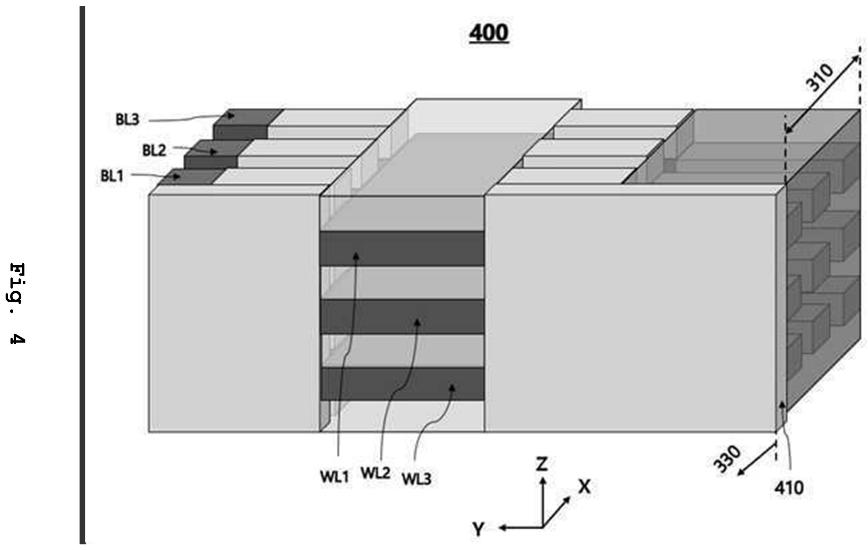

FIG. 4 is a partial three-dimensional view illustrating an embodiment of the present invention to aid understanding, and is a diagram illustrating that an insulating film 410 between the cell region 310 and the contact region 330 is in the shape of a vertical wall. It should be noted in advance that the source S and the gate G of FIG. 3 are substituted and represented as bit lines BL1 to BL3 and word lines WL1 to WL3 in FIG. 4 and other drawings in order to clearly show what role each component will play when stacked in three dimensions in the future. Referring to FIG. 4, each of the plurality of word line layers WL1, WL2, and WL3 is stacked in the Z direction while being insulated from each other, and extends in the X direction, which is the cell region 310. In addition, the plurality of word line layers WL1, WL2, and WL3 extend to and are stacked in the contact region 310 (for convenience, the extended portion is not illustrated in FIG. 4 to emphasize the insulating film 410). Since these layers will eventually function as the gates of the access transistors of the memory cell in the future, it is preferable that each word line and gate be formed on the same layer and with the same material. The sources S of the access transistor are connected to each of the plurality of vertically formed bit lines BL1 to BL3, and are responsible for inputting and outputting data to the capacitor through the access transistor.

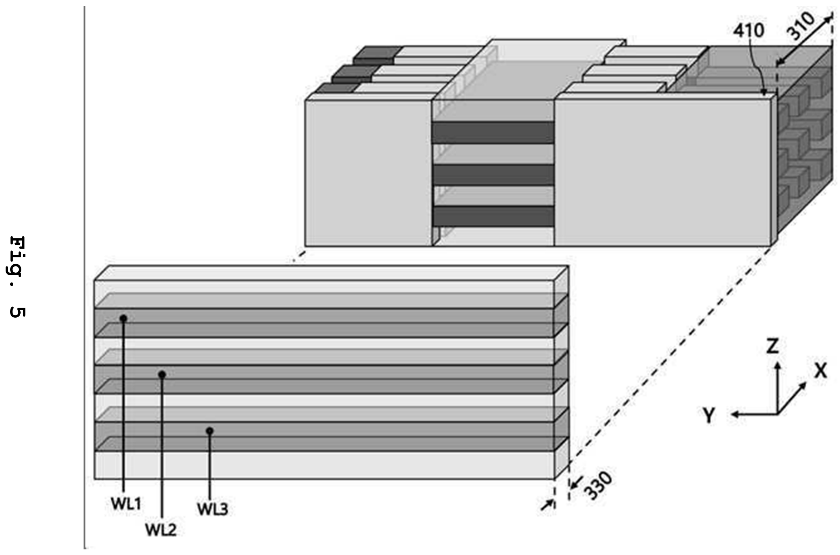

Hereinafter, the process of forming the step-like contact of the present invention will be sequentially described with reference to the drawings of FIGS. 5 to 10. This description will facilitate the understanding that a plan view like that of FIG. 3 may be obtained.

For convenience of description, FIG. 5 is an exploded view of the contact region 330 in FIG. 4, including the contact region 330. The plurality of word line layers WL1 to WL3 are formed in the contact region 330 by continuously extending along the wall surface on which the capacitors are stacked with an insulating film 410 therebetween. Since the plurality of word line layers WL1 to WL3 are inherently separated by an insulator, no separate reference numerals are assigned to WL1 to WL3. The word lines can extend to a certain extent in the opposite direction of the wall surface on which the capacitors are stacked, that is, toward the bit lines. That is, the word lines can extend in both the positive (+) Y direction and the negative (-) Y direction. In the specification of the present invention, when there is no need to distinguish between the positive (+) Y direction and the negative (-) Y direction, the positive (+) Y direction and the negative (-) Y direction are collectively referred to as the 'Y direction'. Although it is preferable that the extensions are formed simultaneously with the formation of each word line layer, the extensions may also be formed separately depending on the convenience of the manufacturing process or the structure of the memory cell.

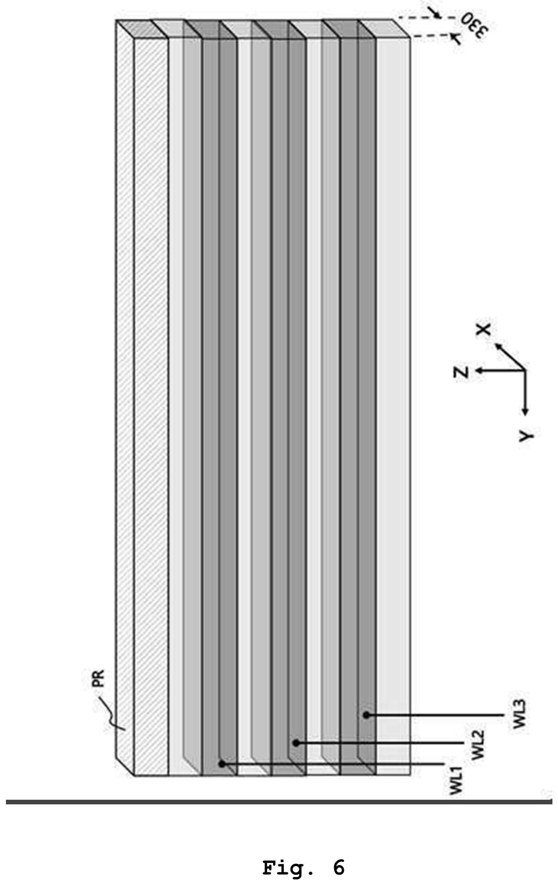

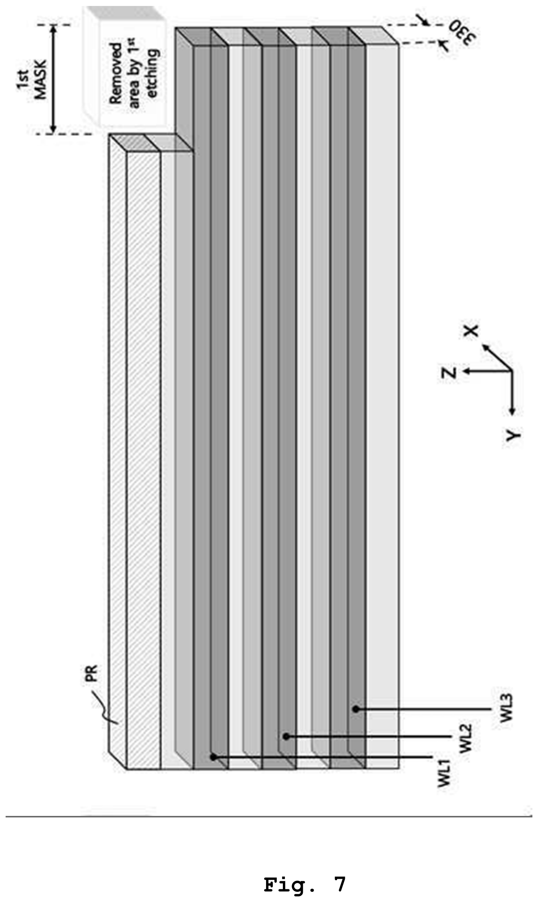

For convenience of description, only the contact region 330 to be formed in a step-like manner is illustrated in FIG. 6. Starting with FIG. 6, the etching process for forming step-like contacts in the word lines WL1 to WL3 will be described with reference to FIGS. 7 to 9. These etching processes are limited to the contact region 330 and do not correspond to the cell region 310. The differences between the etching processes for the contact region 330 and the cell region 310 will be described later.

FIG. 7 illustrates a region that is opened and etched using a first photo mask (hereinafter referred to as "mask"). The etching is preferably anisotropic etching. In the first etching process, a portion of the region where a plurality of contacts will be formed is opened. When the photo resist (PR) and a portion of the insulator are removed by the etching, a portion of the word line WL1 is exposed. This photolithography process, which uses the photo resist and a photo mask, is well known to those skilled in the art, so detailed and technical details will be omitted.

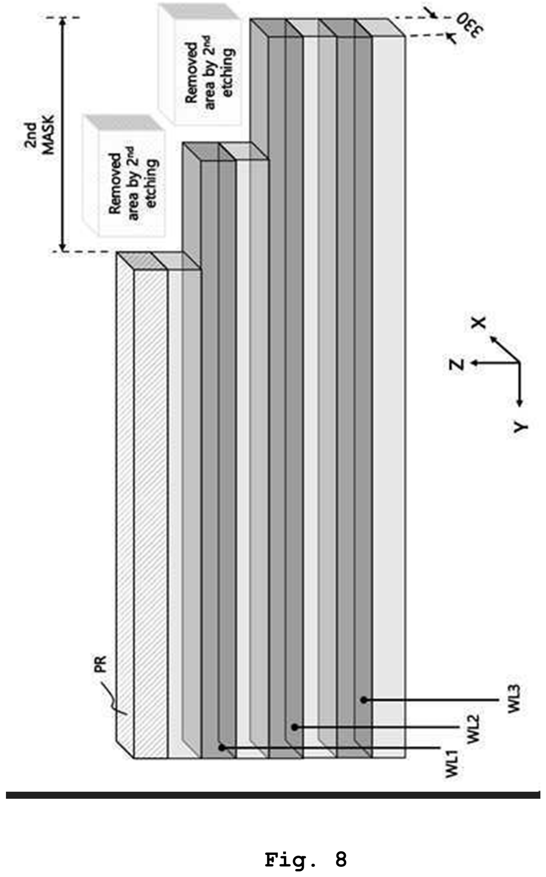

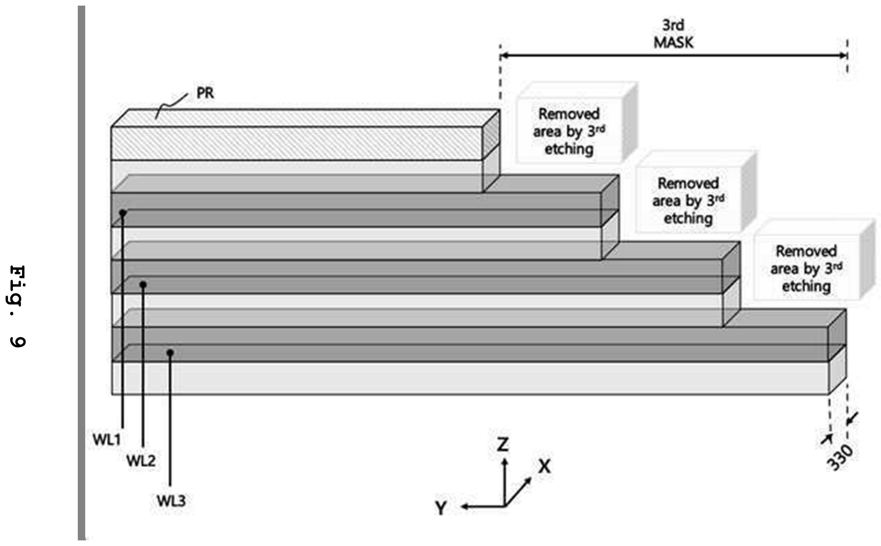

FIG. 8 illustrates a region that is opened and etched using a second mask. In the second etching process, a region wider than the first etching region is etched. To implement this, the second mask should be wider than the first mask. Since the region first etched remains open during the second etching, it is also etched together, and thus a stepped contact (electrode) is formed through the two etching processes. The third etching process is illustrated in FIG. 9 using the same method. Therefore, a portion of each word line WL1 to WL3 is exposed in a step-like manner to form contacts for each of the three word lines.

Referring to FIGS. 7 to 9, the direction in which the step descends is the negative (-) Z direction, and the direction in which the step extends for contact is the negative (-) Y direction.

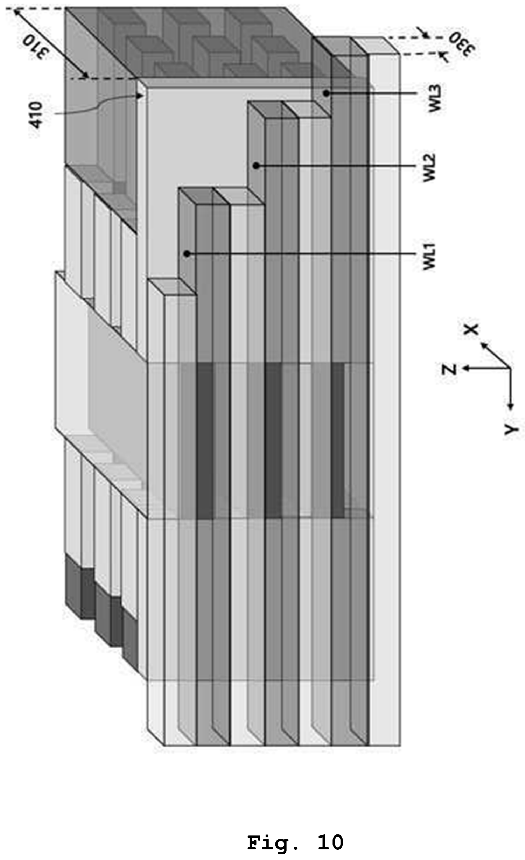

After this etching step, as illustrated in FIG. 10, each word line of the contact region 330 is exposed in the step-like manner. Thereafter, the electrical connection through the step-like contact is possible by filling the contact region 330 with the conductive material. While the etching process that exposes the contact region 330 in the step-like manner is performed, the cell region 310 should not be etched, or even if the cell region is etched, the extent of etching of the cell region should be kept to a minimum. This ensures that structures such as transistors or capacitors under the cell region 310 may be preserved without being damaged. Therefore, the cell region 310 should be covered with a layer of a material with a sufficiently different etching selectivity to protect the cell region 310 from the etching of the contact region. For example, the etching selectivity of the photo resist covering the cell region 310 and the photo resist covering the contact region 330, or similar coating materials, should differ by at least several tens of times. For example, when the etching selectivity of the two photo resists is 1:10, the etching rate of the contact region will be 10 times, which is sufficient to form at least 8 steps. To form 16 steps, a material with an etching selectivity exceeding 1:16 should be selected, or alternatively, after forming eight steps, the corresponding photo resist layer should be removed and then recoated, followed by a process of forming the remaining eight steps.

Referring to FIGS. 7 to 10, the features of the plurality of word lines electrically connecting the 3D DRAM cells 300 and their step electrodes are as follows.

Feature 1: The plurality of word lines WL1 to WL3 extend to a contact region 330 outside the cell region 310 for electrical connection, and the step electrodes are formed in the contact region 330 for each word line.

Feature 2: The steps are not formed in the word line direction (X direction) in which the gate layer G of the access transistor is formed, but in the direction (Y direction) extending along the sidewall of the insulating film 410 which is perpendicular thereto.

Feature 3: The Y-direction length of each word line differs by the length of the steps, and the width occupied by the contact region is the same as the width occupied by a single contact, regardless of the number of contacts or the number of stacks, minimizing the area consumption by the contact region.

The features of the present invention described above may be modified and applied to the bit lines as well as the word lines. Hereinafter, other embodiments of the present invention will be described.

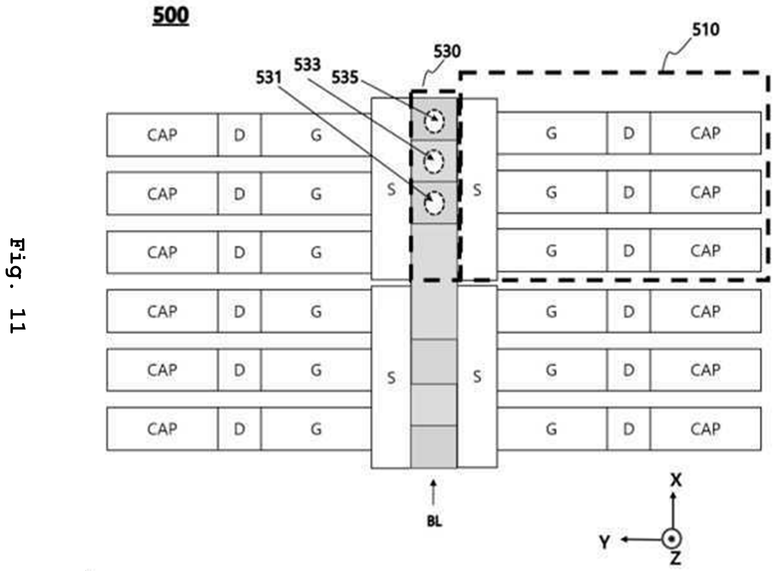

FIG. 11 is a plan view of a 3D DRAM using step electrodes according to another embodiment of the present invention. That is, FIG. 11 is a diagram viewed downward in the Z direction, with bit lines BLs extending along the X-Y plane and stacked in multiple layers as the bit lines BLs descend. The description will focus solely on the unit array indicated by the dotted line among the four unit arrays. This assumption is merely for convenience for describing another embodiment of the present invention illustrated in FIG. 11, and should be noted that the present invention is not limited thereto. In FIG. 11, although a single unit array is illustrated as including only three bits or three DRAM cells, this is merely for convenience of description. In the actual application, it is apparent that the DRAM cells would be repeatedly arranged with more than three bits. As illustrated in FIG. 1, a single-bit unit DRAM cell includes one access transistor and one capacitor. Therefore, each layer has such unit DRAM cells arranged planarly in each array, and in the 3D DRAM, these arrays are repeatedly stacked, as in the foregoing embodiment.

Referring to FIG. 11, in a 3D DRAM cell 500, an access transistor composed of a gate G, a drain D, and a source S, and a capacitor CAP are repeatedly arranged in each layer. The source S, drain D, and capacitor CAP regions are merely a simplified planar representation of the regions they occupy, and are not intended to specifically illustrate the connection relationships of each component. In FIG. 11, the source S commonly used by the three access transistors will later be connected to each bit line BL contact via the step electrodes, thereby enabling the data input/output.

In FIG. 11, the region where the memory cells are repeatedly arranged is indicated as a cell region 510, and a contact region 530 where the bit line BL contacts are formed. The contacts that will be opened later for the step electrodes of each bit line BL layer are indicated by reference numerals 531, 533, and 535. The contacts, indicated by circles, may have various shapes to facilitate the manufacturing process. It should be further noted that, in another embodiment of the present invention, the step-like contacts 531, 533, and 535 are formed by extending in the X-direction. In other words, the steps are formed in the X-direction.

FIG. 11 illustrates a three-dimensional representation of one unit array corresponding to the dotted line among the four unit arrays. Here, the contact region 530 is simply a layer where the source S region extends outward, so the contact region 530 and the source S region are illustrated as the same layer. In this case, a portion of the region occupied by the source S becomes the contact region 530. The width of the extended portion is the same for each contact region. Therefore, the extent to which parasitic capacitance increases due to the extension is minimized.

The following description will describe the process of forming a portion of the source S region into the contact region 530. Naturally, the contact region (530) being formed separately from the source (S) later for the convenience of the manufacturing process or material selection is also included in the technical spirit of the present invention.

Furthermore, since the source S and the bit line BL are electrically connected and therefore have the same potential, these terms are sometimes used interchangeably throughout the present specification. This also applies to the gate G and word line WL.

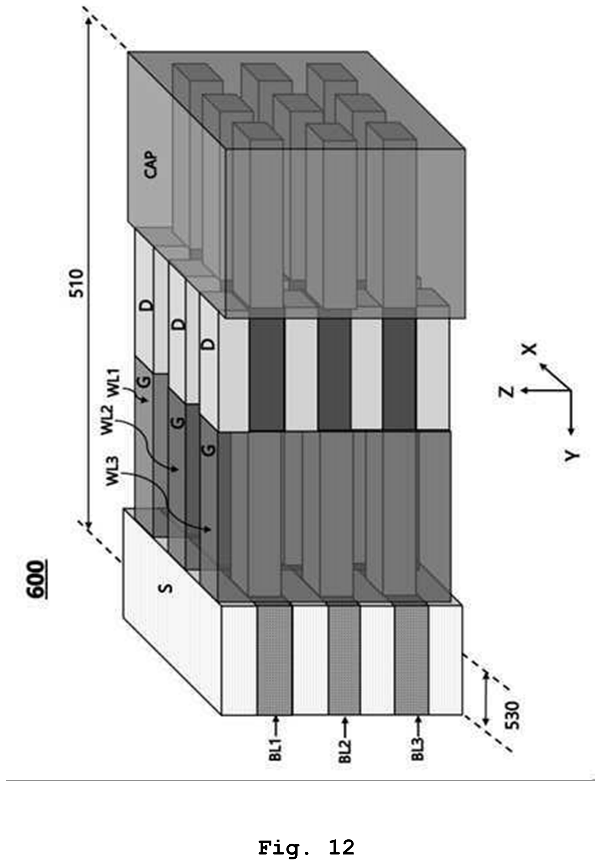

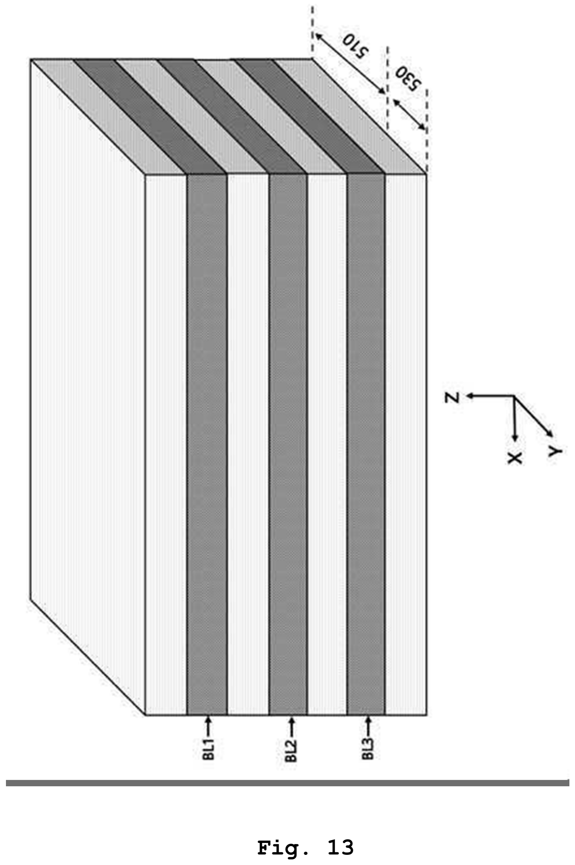

FIG. 13 is a three-dimensional view of only the source S region where the contact region 530 will be formed in FIG. 12, viewed from the Y direction. Some regions of FIG. 13 are indicated as the cell region 510, while others are indicated as the contact region 530. This is because the source S region is included in the cell region 510. To better understand FIG. 13, it should be noted that, unlike the embodiment of FIG. 6, the direction of perspective has changed, and this should be referenced with respect to the three-dimensional coordinates (X, Y, Z) indicated in each drawing.

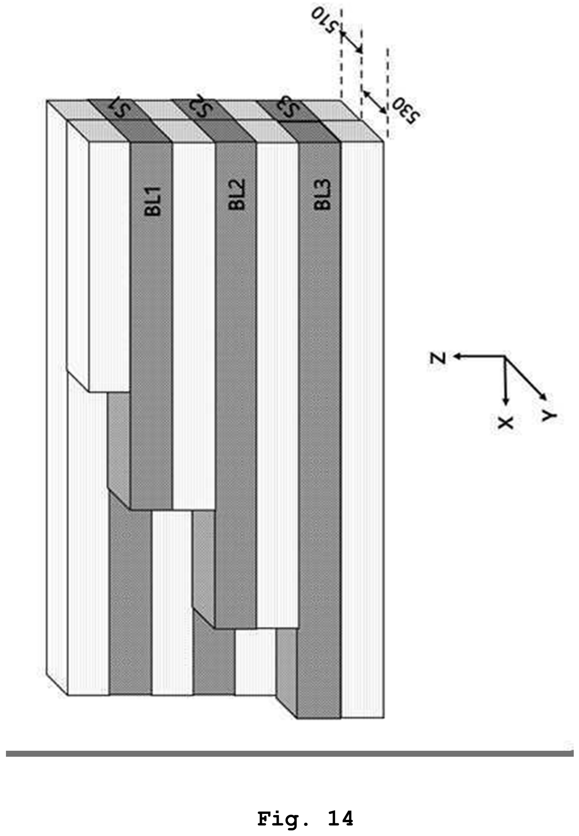

As in the above-described embodiment, the three-dimensional view of the step electrodes formed by repeating the etching process for the contact region 530 is illustrated in FIG. 14. As described above, it is natural that only the contact region 530 should be etched using a material having a different etching selectivity than the cell region 510 and the contact region 530 while repeating the etching process. It should be noted that each of the bit lines BL1 to BL3 and the source S1 to S3 is electrically connected to each other, and are preferably made of the same layer and the same material, and assigned different names depending on the region. It is natural that the insulating film or insulator should exist between each bit line layer, so drawing symbols are not necessarily indicated therein.

As described above, the 3D DRAM using step electrodes according to the present invention, by using the word lines or bit lines in the form of the step electrodes, it is possible to minimize the area occupied by the step electrodes.

Effects which can be achieved by the present invention are not limited to the above-described effects. That is, other effects that are not described may be obviously understood by those skilled in the art to which the present invention pertains from the following description.

Although the technical idea of the present invention has been described above with the attached drawings, this is merely an example of a preferred embodiment of the present invention and does not limit the present invention. In addition, it is obvious that those skilled in the art can make various modifications and imitations within the scope of the technical idea of the present invention without departing from the scope of the technical idea of the present invention.

## Claims

1. A 3D DRAM, in which a plurality of unit DRAM cells, each including an access transistor and a capacitor, are stacked three-dimensionally,
wherein gate terminals of the access transistors arranged in one layer of the unit DRAM cells are connected to a first word line,
gate terminals of access transistors arranged in another layer of the unit DRAM cells are connected to a second word line,
a step is formed between a first contact region for electrical connection of the first word line and a second contact region for electrical connection of the second word line, and
a direction of the step is formed perpendicular to a direction in which the gate terminals are arranged.

2. The 3D DRAM of claim 1, wherein the step extends in a longitudinal direction of the capacitor, and when the first contact region is located in an upper layer, a length of the first word line extending in the longitudinal direction is shorter than a length of the second word line.

3. The 3D DRAM of claim 1 or 2, wherein a number of etching processes for the first contact region is greater than a number of etching processes for the second contact region.

4. The 3D DRAM of any of the preceding claims, wherein an insulating film is present between a cell region in which the capacitors are arrayed and a region in which the first contact region and the second contact region are present.

5. The 3D DRAM of any of the preceding claims, wherein the first word line and the second word line are disposed in a horizontal layer and are made of a same material as gates of the unit DRAM cells belonging to the corresponding layer.

6. The 3D DRAM of any of the preceding claims, wherein one terminal of the access transistor is connected to a vertical bit line.

7. The 3D DRAM of any of the preceding claims, wherein at least some of the unit DRAM cells stacked at a same vertical position have gate terminals that commonly form one vertical word line, and
each contact region forms a step in a horizontal direction while one terminal of the access transistor is perpendicular to the vertical word line.

8. The 3D DRAM of claim 7, wherein each contact region is independently connected to a horizontal bit line and is formed on an extended portion of one terminal layer of the access transistor.

9. The 3D DRAM of claim 7 or 8, wherein a direction in which each contact region is formed is parallel to a direction in which the vertical word line is repeatedly arranged.

10. The 3D DRAM of any one of claims 7 to 9, wherein a number of etching processes for forming an upper contact region is greater than a number of etching processes for forming a lower contact region.

11. The 3D DRAM of any of the preceding claims, wherein word lines connected to gate terminals of access transistors extend in a first direction in a three-dimensional space,
bit lines connected to source terminals of access transistors extend in a vertical direction while perpendicular to the first direction, and
a direction of a step contact for electrical connection of the word line is perpendicular to both the first direction and the vertical direction.

12. The 3D DRAM of any of the preceding claims, wherein bit lines in respective layers extend in a horizontal direction perpendicular to the first direction, and
a direction of a step contact for electrical connection of the bit line is the same as the horizontal direction.

13. A processing method for manufacturing a 3D DRAM, comprising:
coating materials having different etching selectivity to a cell region in which an array of 3D DRAM cells is repeatedly stacked and a contact region in which a step contact is formed for electrical connection;
performing a first etching on one layer to form the contact region;
performing a second etching on a layer below the one layer to form the contact region;
and etching, during the second etching, a portion formed by the first etching.

14. The processing method of claim 13, wherein a mask for the second etching is wider than a mask for the first etching.

15. The processing method of claim 13 or 14, wherein a coating material of the cell region and a coating material of the contact region have different etching selectivity.
